# EUROPEAN PATENT SPECIFICATION

(11) **EP 2 341 298 B1**
(45) Date of publication and mention of the grant of the patent: **05.04.2017**
(21) Application number: 09818825.3
(22) Date of filing: 01.10.2009
(51) Int. Cl.: F24J 2/50, F24J 2/10, F24J 2/46, G02B 1/10, G02B 19/00, G02B 5/08, F24J 2/14, H01L 31/052, H01L 31/054

(54) **PANEL FOR THERMAL SOLAR COLLECTORS**
PLATTE FÜR SONNENWÄRMEKOLLEKTOREN
PLAQUE POUR COLLECTEURS THERMOSOLAIRES

(30) Priority: 10.10.2008 ES 200802875
(43) Date of publication of application: 06.07.2011
(73) Proprietor: Alucoil S.A., 09200 Miranda de Ebro (ES)
(72) Inventor: Gonzalez Soler, Clemente, E-09200 Miranda de Ebro (Burgos) (ES)
(74) Representative: Matamoron Hernandez, José Pedro
(86) International application number: PCT/ES2009/000479
(87) International publication number: WO 2010/040871

(56) References cited:
- FR-A1- 2 354 296
- GB-A- 989 395
- US-A- 3 912 380
- US-A- 4 229 077
- US-A- 4 343 533
- US-A- 4 343 533
- US-A1- 2007 134 501
- US-A1- 2007 178 316

## Description

### PURPOSE OF THE INVENTION

The present invention relates to a plate as those used for the formation of solar thermal collectors, especially collectors that act as a means of reflection and concentration of solar radiation on an absorber pipe or other similar item.

The object of the invention is to achieve a light, resilient and manageable, plate without lessening its performance as a concentration reflector of the solar radiation reflected thereof.

The invention is placed in the field of industry dedicated to manufacture solar thermal collectors.

### BACKGROUND

There are various systems for solar energy collection, among which it's worth noting for their fundamental importance, the collectors based on reflectors able to concentrate solar radiation affecting an absorbing element, in which a heat-transfer fluid reaches a sufficient temperature level to supply steam through a heat exchanger to a turbine associated with an electricity generator.

A special mention deserve the parabolic cylinder collectors, in which the surface reflectors are embodied in a plurality of curved plates, which properly inter coupled, configure a curved surface itself of parabolic generation where, in correspondence to its focal line, an absorber pipe through which the heat-transfer fluid circulates, is placed.

These reflectors materialize in practice in glass mirrors that by their own nature present a problem that is primarily focused on the following aspects:
- By their curvature the manufacturing is complex.
- By their nature they are of considerable weight.
- They are fragile and by their fragility the dimensions of the plates are significantly limited.
- For the same reasons their assembly is slow, complicated and costly.

Trying to solve this problem, it is known the patent US 4343533, in which the classic reflectors based on glass mirrors are replaced by a sheet made of metal, arranged on a core with a substrate of cellulosic material, preferably corrugated cardboard, integrated with a weather US 4343533 discloses the preamble of claim 1.

The cellulose nature of this core results in a very low resistance, which would be desirable to increase, while, even though manufacturing costs and the weight of the device are reduced, its capture efficiency is limited by the very nature and the finish of the reflective surface.

### DESCRIPTION OF THE INVENTION

The plate for solar thermal collectors that the invention proposes solves in a fully satisfactory manner the aforementioned problems in the various aspects discussed.

To that end and more specifically, the invention is based mainly on the substitution of the classic mirror based reflectors for aluminium reflector sheets.

The aluminium reflector sheet, which for its reduced thickness is not self-supporting, must be supported by a nucleus that gives the adequate mechanical strength, without altering its curvature and its disposition with respect to the absorber pipe and also the repeatedly mentioned aluminium sheet is equipped with protective coatings against atmospheric or environmental agents.

More specifically, the proposed plate is a stratified plate in which the said nucleus is obtained from mineral fibres, thermoplastic resins or similar, with a thickness of between 1 mm and 5 mm. Said nucleus gives the plate, as a whole, sufficient strength, rigidity and conformation.

This nucleus receives on its outer side, that is, the side oriented toward the sun, an aluminium reflector sheet that, as previously stated, constitutes the mirror element with a thickness of about 0.3 mm, said sheet coated on both sides with respective layers of anodized, while the nucleus receives through its opposite face to the aluminium reflector sheet, aluminium of 99.9% purity alloy and a layer of primer.

The aluminium reflector sheet is in turn protected by the outer face of the plate, meaning the one facing the solar radiation, through a first layer of PVD (Physical Vapour Deposition) and finally a transparent inorganic coating for outdoor use.

### DESCRIPTION OF THE DRAWINGS

To complement the description that is being made and for a better comprehension of the features of the invention according to the preferred actual embodiment thereof, a set of drawings as an illustration and not limited to, is attached as an integrated part of said description showing the following:
Figure 1. shows, according to a schematic representation in perspective, a solar thermal collector plate of energy made according to the object of this invention.
Figure 2. shows an enlarged detail and a section of said plate which clearly shows the stratification thereof.

### PREFERRED EXECUTION OF THE INVENTION

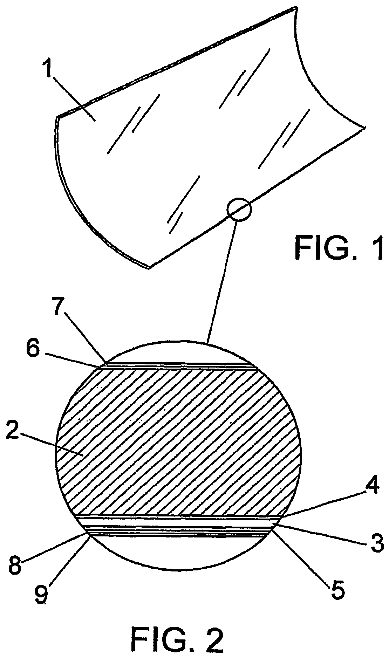

Figure 1 represents a reflector plate (1) in the form of a cylindrical surface segment, wherein said plate (1) is intended, specifically in this example of practical implementation, for parabolic cylinder collectors, but obviously the plate could be flat for other type of collectors, as for example those used for water heating or Fresnel solar thermal mirrors.

Therefore, as shown in Figure 2, in said plate there is a support or nucleus with an overall thickness in its context obtained from mineral fibres and thermoplastic resins, or similar, which allows to give the plate on the whole any configuration as for example the one shown in Figure 1, and maintain this configuration in a stable way.

This nucleus (2) receives on its concave face, or more generally speaking, on its side facing the solar radiation, an (3) aluminium reflector sheet coated on both sides by layers of anodized (4, 5), at the same time said nucleus(2) receives on its opposite face an aluminium alloy (6) with a primer (7) on its outer face.

In turn the aluminium reflector sheet(3) is protected on its outer side by means of a layer of PVD (Physical Vapour Deposition) (8) and a transparent inorganic coating for outdoor use(9), that protects said reflector against the environmental effects.

Thus, a plate with a considerably reduced weight than that of conventional mirror based plates, is obtained with high mechanical resistance and perfect formal stability due to the nature of its nucleus (2), allowing in turn to use in the collector a smaller number of plates which allows an ease of assembly, both for its strength and lightness, the absence of risk of breakage and the possibility to make fixing holes in any desired point, said plate depending on its size can have an overall thickness between 2 and 6 mm.

## Claims

1. Plate for thermal solar collectors, applied particularly to parabolic trough collectors, wherein specular reflectors are used that concentrate solar radiation on a receiver tube located on the focal line, comprising a laminated body with a core (2) used as a supporting element, **characterised in that** said core (2) is obtained from mineral fibers and thermoplastic resins, thereby giving the plate as a whole the required rigidity, mechanical consistency and stability of form, a sheet of aluminium foil (3) associated with said core (2) on the face oriented towards the solar radiation, a layer of PVD (Physical Vapour Deposition) (8) associated with the sheet of aluminium foil (3) on its outer face, a layer of transparent inorganic varnish (9) for outdoor use covering the PVD layer and a layer of aluminium alloy (6) associated with the opposite face of the core (2) provided with a primer layer (7) for outdoor use.

2. Plate for thermal solar collectors according to claim 1, **characterised in that** the reflective aluminium foil (3) is coated on both sides by respective anodized layers (4 and 5).

3. Plate for thermal solar collectors according to claims 1 and 2, **characterised in that** the core (2) has a thickness between 1 and 5 mm, the reflective aluminium foil (3) has a thickness between 0.3 and 0.8 mm and the plate as a whole has a thickness between 2 and 6 mm.

## Patentansprüche

1. Platte für thermische Solarkollektoren, die insbesondere bei Parabolrinnenkollektoren angewendet wird, in denen Spiegelreflektoren zum Einsatz kommen, die die Sonnenstrahlung auf einem in der Brennlinie liegenden Receiverrohr konzentrieren, umfassend einen als Stützelement verwendeten laminierten Körper mit einem Kern (2), **dadurch gekennzeichnet, dass** der besagte Kern (2) aus Mineralfasern und thermoplastischen Harzen gewonnen wird und der Platte somit insgesamt die erforderliche Steifigkeit, mechanische Konsistenz und Formstabilität verleiht, einem mit dem besagten Kern (2) verbundenen Blech aus Aluminiumfolie (3) auf der zur Sonnenstrahlung gerichteten Seite, einer mit dem Blech aus Aluminiumfolie (3) verbundenen PVD-Schicht (physikalische Gasphasenabscheidung) (8) auf dessen Außenseite, einer Schicht aus durchsichtigem anorganischem Lack (9) zur Außenanwendung, die die PVD-Schicht bedeckt, und einer Schicht aus einer Aluminiumlegierung (6), die mit der gegenüberliegenden Seite des Kerns (2) verbunden und mit einer Primerschicht (7) zur Außenanwendung versehen ist.

2. Platte für thermische Solarkollektoren nach Anspruch 1, **dadurch gekennzeichnet, dass** die reflektierende Aluminiumfolie (3) auf beiden Seiten mit entsprechenden Eloxalschichten (4 und 5) beschichtet ist.

3. Platte für thermische Solarkollektoren nach den Ansprüchen 1 und 2, **dadurch gekennzeichnet, dass** der Kern (2) eine Stärke zwischen 1 und 5 mm aufweist, die reflektierende Aluminiumfolie (3) eine Stärke zwischen 0,3 und 0,8 mm aufweist und die Platte insgesamt eine Stärke zwischen 2 und 6 mm aufweist.

## Revendications

1. Plaque pour collecteurs solaires thermiques, à appliquer particulièrement sur des collecteurs cylindro-paraboliques, dans lesquels des réflecteurs spéculaires sont utilisés pour concentrer le rayonnement solaire sur un tube récepteur situé sur la ligne focale, comprenant un corps laminé avec un noyau (2) utilisé comme un élément support, **caractérisée en ce que** ledit noyau (2) est constitué de fibres minérales et de résines thermoplastiques, de sorte à fournir à l'ensemble de la plaque la rigidité nécessaire, ainsi que la résistance mécanique et la stabilité de forme, une tôle en aluminium (3) associée audit noyau (2) sur la face orientée vers le rayonnement solaire, une couche de PVD (déposition en phase gazeuse) (8) associée à la tôle en aluminium (3) sur sa face extérieure, une couche de vernis inorganique transparent (9) pour usage extérieur destinée à recouvrir la couche de PVD et une couche en alliage d'aluminium (6) associée à la face opposée du noyau (2) doté d'une première couche (7) pour usage extérieur.

2. Plaque pour collecteurs solaires thermiques selon la revendication 1, **caractérisée en ce que** la tôle en aluminium réfléchissante (3) est recouverte des deux côtés par les couches anodisées respectives (4 et 5).

3. Plaque pour collecteurs solaires thermiques selon les revendications 1 et 2, **caractérisée en ce que** le noyau (2) a une épaisseur comprise entre 1 et 5 mm, la tôle en aluminium réfléchissante (3) a une épaisseur comprise entre 0.3 et 0.8 mm et la plaque entière a une épaisseur comprise entre 2 et 6 mm.
